# EUROPEAN PATENT APPLICATION

(11) **EP 4 804 349 A1**
(43) Date of publication of application: **09.09.2026**
(21) Application number: 25161793.2
(22) Date of filing: 05.03.2025
(51) Int. Cl.: H01S 5/02345, H01S 5/062, H01S 5/02212, H01S 5/024

(54) **HEADER FOR AN OPTOELECTRONIC COMPONENT**

(71) Applicant: SCHOTT AG, 55122 Mainz (DE); SCHOTT Singapore Pte. Ltd., 738959 Singapore (SG)
(72) Inventor: HETTLER, Robert, 84028 Landshut (DE); LI, Ong Wai, 738959 Singapore (SG); WONG, Yin Cheng, 738959 Singapore (SG); SOON, Amy, 738959 Singapore (SG); DRÖGEMÜLLER, Karsten, 82223 Eichenau (DE); AOWUDOMSUK, Artit, 10210 Bangkok (TH)
(74) Representative: Schott Corporate IP

(57) **Abstract**

A header (1) for an optoelectronic component (90) is provided comprising a header base (10) having at least one signal pin (20) which is fed through an opening (12) in the header base (10) and fixed within the opening (12) with a fixation material (30), a component pedestal (60) having a component submount (70) configured for mounting the optoelectronic component (90), and a signal pedestal (40), wherein a signal submount (50) is arranged on the signal pedestal (40), the signal submount (50) having a signal trace (52) which is electrically connected to the signal pin (20). The signal submount (50) has a thickness of at most 150 µm, and/or
the signal submount (50) has at least one grounded side trace (54), the width D of the signal submount (50) is at most 1000 µm, the thickness H of the signal submount (50) is in the range of from 150 µm to 300 µm, and a slot width S between the signal trace (52) and the grounded side trace (54) S is at least 100 µm, and/or
a first side face (561) of the signal submount (50) is at least partially metallized and/or a plurality of vias (58, 59) is arranged adjacent to the first side face (561) to provide a ground shield, and an opposing second side face (562) of the signal submount (50) is free from a ground shield.

## Description

The invention relates to an header for an optoelectronic component comprising a header base having at least one signal pin which is fed through an opening in the header base and fixed within the opening with a fixation material, a component pedestal having a component submount configured for mounting the optoelectronic component and a signal pedestal, wherein a signal submount is arranged on the signal pedestal, the signal submount having a signal trace which is electrically connected to the signal pin.

### Prior art

Packages for optoelectronic components such as laser diodes are in principle known. A common type are transistor outline (TO) packages with glass-sealed signal pins. Such a TO package generally comprises a header base made of metal, through which at least one signal pin extends which is fitted in a glass feedthrough. The signal pin can be used to electrically connect an optoelectronic component. Within the package, submounts comprising a signal trace carry the electrical signal from the signal pin to the optoelectronic component. A TO package suitable for speeds up to 100 Gbit/s per wavelength is, for example, known from US 11,256,048 B2. With increasing data rate and thus increasing bandwidth of the electrical signal, it becomes more and more difficult to conduct the signal while avoiding resonances and excessive signal loss.

US 2023/0097003 A1 discloses a conductor track arrangement for high frequency signals. The conductor track for the high frequency signal is bent by 90° to feed the signal from the signal pin of the header to the optoelectronic component. Disturbance of the RF signal due to an impedance change in the bent section of the conductor track is avoided by changing the distance between the conductors.

The known headers are unsuited for signals having frequencies in excess of about 50 GHz.

### Disclosure of the invention

A header for an optoelectronic component is provided, comprising a header base having at least one signal pin which is fed through an opening in the header base and fixed within the opening with a fixation material, a component pedestal having a component submount configured for mounting the optoelectronic component, and a signal pedestal, wherein a signal submount is arranged on the signal pedestal, the signal submount having a signal trace which is electrically connected to the signal pin,

In order to ensure a high signal bandwidth for an electrical signal, the signal submount is configured and arranged such that
i) the signal submount has a signal submount thickness H of at most 150 µm, preferably in the range of from 100 µm to 150 µm, especially preferred in the range of from 100 µm to 125 µm, wherein the signal submount is arranged such that an offset between a plane of the signal trace of the signal submount to the plane of a component signal trace of the component submount is less than +/- 200 µm, preferably less than +/- 100 µm, and/or
ii) the signal submount has at least one grounded side trace, the width D of the signal submount is at most 1000 µm, the thickness H of the signal submount is in the range of from 150 µm to 300 µm, preferably from 150 µm to 250 µm, and a slot width S between the signal trace and the grounded side trace S is at least 100 µm; and/or
iii) the signal submount has a ground plane on the side opposite to the signal trace, wherein a first side face of the signal submount is at least partially metallized and/or a plurality of vias is arranged adjacent to the first side face to provide a ground shield, and an opposing second side face of the signal submount is free from a ground shield.

The three proposed measures i), ii) and iii) can be used independently or in any combination. The signal submount of the header is preferably configured and arranged such that the signal submount has bandwidth for an electrical signal of at least 75 GHz, preferably at least 80 GHz, more preferably at least 90 GHz. This bandwidth is defined as the range from 0 Hz up to the frequency for which the insertion loss of an electrical signal inserted on a first end of the signal trace facing towards the signal pin and transmitted to a second end facing towards the component submount exceeds 50% signal loss (-3dB) for the first time.

The signal trace on the signal submount is part of a waveguide for transmitting high frequency electrical signals. Such a waveguide can be arranged in several configurations, such as a microstrip line, a slot line or a coplanar waveguide.

A microstrip transmission line consists of a narrow metal strip, typically copper or gold as conductor, embedded in a dielectric substrate with a ground plane beneath it. The metal strip serves as the signal conductor, while the ground plane provides a return path for the current. The dielectric material between the strip and the ground plane determines the characteristic impedance and propagation velocity of the signal.

A conductor-backed slot line with finite ground plane width comprises a narrow metal strip as signal line flanked by a ground line embedded in a dielectric substrate.

A grounded coplanar waveguide consists of a central signal strip flanked by two ground planes, all embedded in a dielectric substrate. The ground planes are typically wider than the signal strip to ensure adequate shielding and minimize radiation loss.

A waveguide suitable for transmitting the signal on the signal submount must be capable of containing the signal within the waveguide and must be able to transmit the signal without excessive damping or undesired resonances.

The inventors have found that a thin submount, which reduces the distance between the signal trace and the opposing ground plane contributes to localizing the signal within the signal submount, in particular, if the signal submount is not offset from the plane of the component submount.

Further, the inventors have found that surprisingly a wide slot width is favorable for containing the signal, in particular for thicker and wider submounts.

Still further, the inventors have found that a ground shield arranged on a side face of the signal submount, between the signal submount and other components of the header, in particular parts of the component pedestal such as the thermoelectric cooler, improve the signal transmission, in particular for configurations which avoid fully enclosing the submount with ground shields. It is assumed that by arranging ground shields on both sides of the submount undesired resonances can occur. This is avoided by the proposed design with an open, unshielded side face facing away from the component submount.

The ground shield on the side face can be provided by fully or partially metallizing the respective side face and connecting the metallized part to ground. Additionally or alternatively, the ground shield can be provided by a plurality of vias which are connected to ground. The width of the section of the side face covered by the ground shield is preferably at least 50 µm wide. Smaller widths are in principle also possible, but a minimum width of 50 µm is preferred for a strong adhesion of a metal coating on the side face.

In case multiple vias are used for providing the ground shield, a distance between two neighboring vias should be less than a quarter of the highest signal frequency for which the header and thus the signal submount is designed. The design frequency is preferably at least 75 GHz.

In case the signal submount comprises one or more of measures i) and ii), the signal submount can be combined with an at least partially metallized side face or can be provided with a plurality of vias, wherein the ground shield can be arranged on the first side face which is facing towards the component submount and/or on a second side face which is facing away from the component submount. The ground shield can be provided in form of a grounded side plane, for example an at least partially metallized side face, or in form of a plurality of vias.

In configurations where the signal submount has a ground side trace on the plane of the signal trace, the ground side trace(s) is/are preferably arranged adjacent to an edge such that the ground side trace is directly electrically connected to and/or merges seamlessly into the ground side plane. A seamless transition can improve the resistance of the metal layer against peeling.

Further, in configurations where the signal submount has a ground side trace on the plane of the signal trace, the end of the signal trace facing towards the component submount is flanked preferably flanked on one or both sides with ground pads being connected to the ground side trace and having a width that is preferably larger than a width of the ground side trace.

A first end of the signal trace which faces towards the signal pin is preferably configured as solder pad for forming a solder connection between the signal trace and the signal pin. The signal pin may be provided with an enlarged collar to reduce a distance between the solder pad and the signal pin. The solder pad may have a width which is larger or smaller than the width of the signal trace. In case of a reduced width of the solder pad, it is preferred that the signal trace is tapered towards the first end.

A second end of the signal trace which faces towards the component submount is preferably configured as a bond pad. One or more bond wires may be attached to the bond pad in order to form an electrical connection between the signal submount and the component submount. The bond pad may have an increased or reduced width compared to the width of the signal trace. By adjusting the size of the bond pad, an electrical capacitance of the signal trace may be adjusted.

Preferably, the signal trace is flanked on one or both sides with ground side traces. The arrangement of grounded side traces on both sides allows a reduction of the width of the signal trace while keeping the same impedance. The smaller the width of the signal trace, the more the electromagnetic field is concentrated around the signal trace. A better concentration of the electromagnetic field provides a reduction of undesired cross talk to other components.

The ground side traces may be provided with ground pads arranged adjacent to the second end of the signal trace. The ground pads are preferably configured for the attachment of bond wires to form a ground connection between the signal submount and the component submount.

Preferably, the signal submount has at least one ground side trace and is configured such that a slot width S between the signal trace and an adjacent ground side trace and width W of the signal trace fulfill the condition S/W is greater than or equal to 0.5, preferably greater than or equal to 0.7.

Preferably, the signal trace has straight section, which may be arranged next to a first end of the signal trace which is facing towards the signal pin. The straight section of the signal trace is preferably arranged in the middle of the signal submount. Within the straight section, the signal trace preferably has a constant width or a taper in a direction towards the signal pin.

The signal trace of the signal submount is, at a first end facing towards the signal pin, preferably arranged parallel to an axis of the signal pin. At a second end facing towards the component submount, the signal trace is preferably arranged at an angle of from 40° to 50° or 80° to 100° relative to the axis of the signal pin, e.g. by 45° or by 90°. This allows changing of the direction of the signal towards the component submount and thus towards an optoelectronic component mounted on the component submount.

The signal pin is fed through an opening in the header base and is fixed inside said opening via a fixation material. The fixation material seals the opening. The fixation material is preferably a glass or a glass ceramic material. In addition to the signal pin, the header preferably comprises additional pins, which are likewise fed through an opening in the header base and fixed via a fixation material. The additional pins may for example be used to power a thermoelectric cooler or to provide electrical connections for a monitoring diode or a temperature sensor. The header base is preferably made from a metal.

The signal pedestal preferably comprises a mounting part which is preferably made from a metal. The mounting part and the header base may be provided in form of a single piece, or the mounting part can be a separate part which is fixed to the header base. The signal submount is preferably mounted on the mounting part of the signal pedestal.

Likewise, the component pedestal preferably comprises a component mounting part which is preferably made from a metal. The component mounting part may have a "L"-shaped profile.

Further, the component pedestal preferably comprises a thermoelectric cooler configured to control the temperature of an optoelectronic component mounted on the component submount. Such a thermoelectric cooler has a cold plate and a hot plate, the cold plate and the hot plate being spaced apart by intermediate Peltier elements. The thermoelectric cooler can be mounted on a surface of the header base. Preferably, the thermoelectric cooler is mounted on the bottom of a cavity in the header base with its hot plate, such that the Peltier elements are arranged at least partially inside the cavity and below a surface level of an upper side of the header base. In such a configuration, the cavity walls provide a shield for avoiding undesired interactions with radio frequency signals. Preferably, the component mounting part is mounted on the cold plate of the thermoelectric cooler and the component submount is mounted on the component mounting part.

The signal submount comprises a dielectric substrate which carries the signal trace and, if present, the ground trace(s). Preferably, the substrate material of the submount is a ceramic, preferably AIN or Al₂O₃.

It has been found that thin signal submounts provide a higher signal bandwidth than thicker signal submounts. Accordingly, the signal submount is preferably configured such that a submount width D and the submount thickness H fulfill the condition D >= 5H.

Additionally or alternatively, it is preferred that the submount width D and the signal trace width W fulfill the condition D>=2.5W as it has been found that the signal trace should be thin compared to the width D of the signal submount.

Another aspect of the invention is the provision of a TO package which comprises one of the headers described herein. The TO package further comprises a cap with a window for transmitting radiation emitted by or to be received by an optoelectronic component mounted on the component submount. The component submount comprises a thermoelectric cooler for temperature control of the electrooptical component. The optoelectronic component and the thermoelectric cooler are encapsulated within the volume formed between the header and the cap. The optoelectronic component is connected to a signal pin fed through the header by means of a signal submount.

The optoelectronic component is preferably a laser diode or a photodiode.

The cap is preferably a metal part which may be obtained by deep drawing.

The window of the cap is preferably configured as a lens. Such a lens may be provided to focus/couple a beam emitted by a laser diode into a core of a fiber optic or to focus light onto a photodiode.

Another aspect of the invention is the provision of an electro-optical converter for high-speed data communication with transmission rates of at least 100 GBit/s, comprising one of the TO packages described herein and a laser diode as optoelectronic component.

Preferred embodiments of the invention are shown in the figures and will be explained in more detail in the following description, wherein identical reference signs refer to identical or similar components or elements.

### Brief description of the figures:

Figure 1 shows a header for an optoelectronic component according to the prior art in a perspective view,
Figure 2 shows a header according to the present disclosure in a perspective view,
Figure 3 shows an enlarged top view of the header
Figure 4 shows a front view of the header,
Figure 5a shows a perspective view of a signal submount in microstrip configuration,
Figure 5b shows a top view of a first example of the signal submount,
Figure 6 shows a diagram indicating the insertion loss for the signal submount shown in figures 5a and 5b,
Figure 7 shows a perspective view of a second example of the signal submount,
Figure 8 shows a perspective view of a third example of the signal submount,
Figure 9 shows a top view of a fourth example of the signal submount,
Figure 10a shows a perspective view of a fifths example of the signal submount,
Figure 10b shows a top view of the fifths example of the signal submount,
Figure 11a shows a perspective of a sixth example of the signal submount,
Figure 11b shows a top view of the sixth example of the signal submount,
Figure 12a shows a perspective of a sevenths example of the signal submount,
Figure 12b shows a top view of the sevenths example of the signal submount,
Figure 13a shows a perspective view of a eights example of the signal submount
Figure 13b shows a perspective view of a variant of the signal submount of figure 13a,
Figure 13c shows a top view of the signal submount of figures 13a and 13b,
Figure 14 shows a top view of a nineths example of the signal submount,
Figure 15a shows a perspective view of an tenths example of the signal submount,
Figure 15b shows a top view of the tenths example of the signal submount,
Figure 16 shows a diagram indicating the insertion loss for a header using the submount of the tenth example,
Figure 17 shows a diagram indicating the -3dB bandwidth of different signal submounts,
Figure 18 shows a perspective view of the header including an optoelectronic component, and
Figure 19 shows a TO housing comprising a header and a window cap.

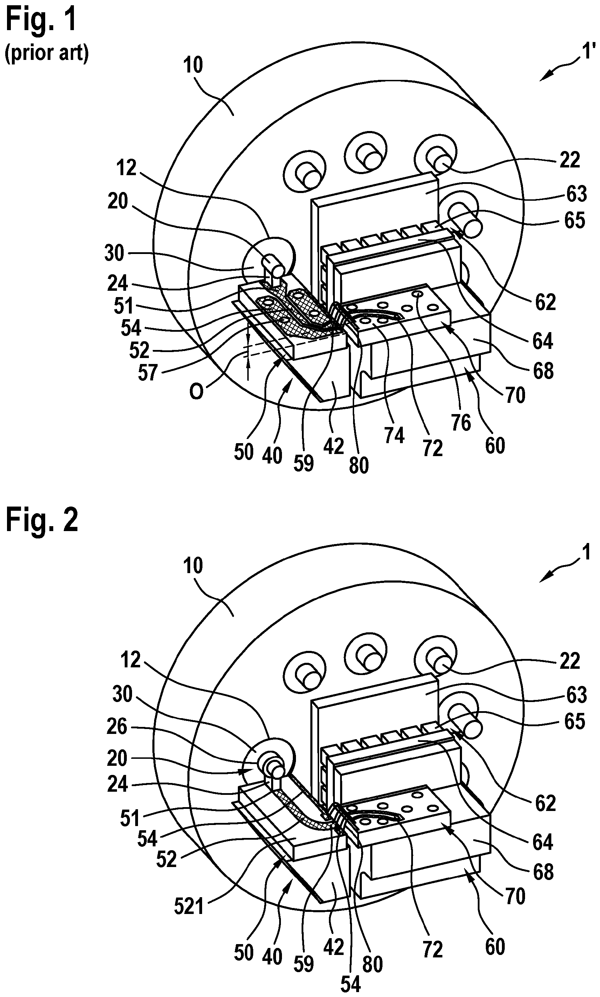

Figure 1 shows a header 1' according to the prior art which is suitable for a transistor outline (TO) package. The header 1' comprises a header base 10 with openings 12 in which electrical conductors in form of pins 20, 22 are fed through. A fixation material 30, such as a glass or a glass ceramic, fix the pins 20, 22 in the openings 12 and seal the openings 12.

For mounting of an optical component, the header 1' comprises a component pedestal 60 which includes a thermoelectric cooler 62 and a component submount 70 for mounting of an optoelectronic component (not shown). The thermoelectric cooler 62 comprises a hot plate 63, which is attached to the header base 10, and a cold plate 64. A mounting part 68, which carries the component submount 70, is attached to the cold plate 64. A plurality of Peltier elements 65 is arranged between the hot plate 63 and the cold plate 64.

Usually, the header base 10 comprises several pins 22 for providing power to a thermoelectric cooler 62 and for connecting components such as a thermal sensor or a monitoring diode. Further, the header base 10 comprises at least one signal pin 20 which is configured to provide a high frequency signal to an optoelectronic component mounted on the component submount 70. In order to conduct a high frequency signal from the signal pin 20 to the component submount 70, a signal pedestal 40 having a mounting part 42 and a signal submount 50 is used. The signal submount 50 comprises a signal trace 52 which is in the shown configuration flanked on both sides with ground side traces 54. Several vias 57 provide a ground connection to the ground side traces 54. The signal trace 52 and the two ground traces 54 form a coplanar waveguide.

The signal trace 52 has a solder pad 51 which is bonded to the signal pin 20 by means of a solder material 24. At the other end, the signal trace 52 has a bond pad 59. Bond wires 80 bridge a gap between the signal submount 50 and the component submount 70 and connect the signal trace 52 to a component signal trace 72 on the component submount 70. Further, several bond wires 80 connect the ground side traces 54 to a ground plane 74 on the component submount 70. Vias 76 connect the ground plane 74 to the backside of the component submount 70. With this arrangement, a high frequency signal may be transmitted from the signal pin 22 via the signal trace 52, the bond wires 80 and the component signal trace 72 to an optoelectronic component.

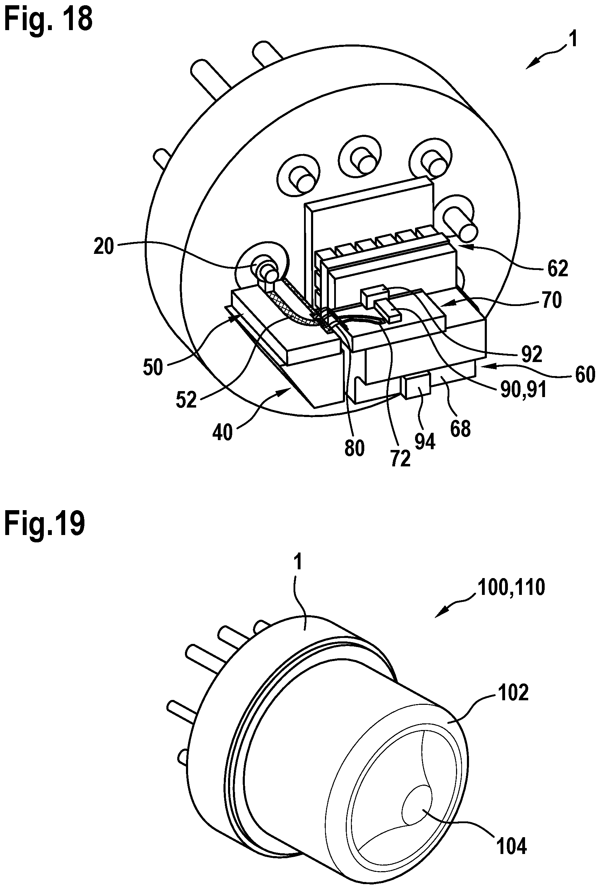

The gap between the component submount 70 and the signal submount 50 reduces the thermal mass that has to be temperature controlled by the thermoelectric cooler 62 and avoids a thermal short between the hot side and a cold side of the thermoelectric cooler 62. Further, in the header 1' according to the prior art, the signal trace 52 on the signal submount 50 and the component signal trace 72 are not arranged in the same plane. The plane of the signal trace 52 and the plane of the component signal trace 72 is offset by an offset O. This offset O increases the lengths of the bond wires 80. This offset O is generally the result of a mismatch of different optimizations, such as the size of the opening 12 for the feed-through to meet 50-ohm impedance, the choice of the thickness of the signal submount 50 to meet the bandwidth requirements, and placement of the signal trace 52 such that a gap to be bridged by the solder 24 to the signal pin 20 is reduced. The optoelectronic component 90 is in the depicted example placed in the center of the header 1 and aligned with a central axis of the header 1. When the package is closed with a cap 102, see figure 19, an optical axis of a lens, such as a coupling lens of the cap 102 is aligned with the central axis of the header 1. The alignment of the optical component 90 determines the placement of the component submount 70.

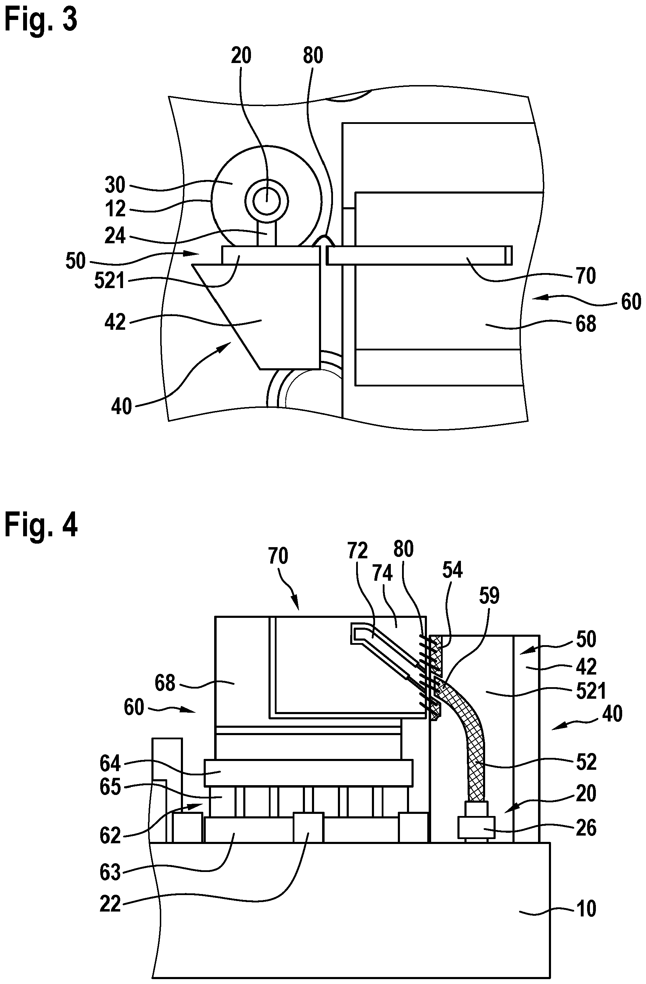

An example of a header 1 according to the present invention is now described with reference to figures 2, 3 and 4. Figure 2 shows a perspective view of the header 1 according to the present invention, figure 3 shows the header 1 in an enlarged top view and figure 4 shows a front view.

The header 1 is suitable for a transistor outline (TO) package and comprises a header base 10 with openings 12 in which electrical conductors in form of pins 20, 22 are fed through. A fixation material 30, such as a glass or a glass ceramic, fixes the pins 20, 22 in the respective openings 12 and seals the openings 12.

For mounting of an optoelectronic component, the header 1 comprises a component pedestal 60. As can be best seen in the front view of figure 4, the component pedestal 60 includes a thermoelectric cooler 62, a mounting part 68 and a component submount 70 for mounting of an optoelectronic component (not shown). The thermoelectric cooler 62 comprises a hot plate 63, which is attached to the header base 10, and a cold plate 64. The mounting part 68, which carries the component submount 70, is attached to the cold plate 64. A plurality of Peltier elements 65 is arranged between the hot plate 63 and the cold plate 64. In the depicted example, the header base 10 has an essentially flat surface and the hot plate 63 is attached to said surface. Alternatively, the header base 10 may comprise a cavity or depression to receive the thermoelectric cooler 62. In such a configuration, the hot plate 63 is attached to the bottom of the cavity or depression. The depths of the cavity or depression is preferably chosen such that the Peltier elements 65 are completely or at least partially arranged within the cavity, the walls of the cavity providing an electromagnetic shielding.

In the depicted example, the header base 10 comprises several pins 22 for providing power to a thermoelectric cooler 62 and for connecting components such as a thermal sensor or a monitoring diode. Further, the header base 10 comprises at least one signal pin 20 which is configured to provide a high frequency signal to an optical component mounted on the component submount 70. In order to conduct a high frequency signal from the signal pin 20 to the component submount 70, a signal pedestal 40 having a mounting part 42 and a signal submount 50 is used.

The mounting part 42 of the signal pedestal 40 can be a separate element which is attached to the header base 10. Alternatively, the mounting part 42 and the header base 10 can be a single piece.

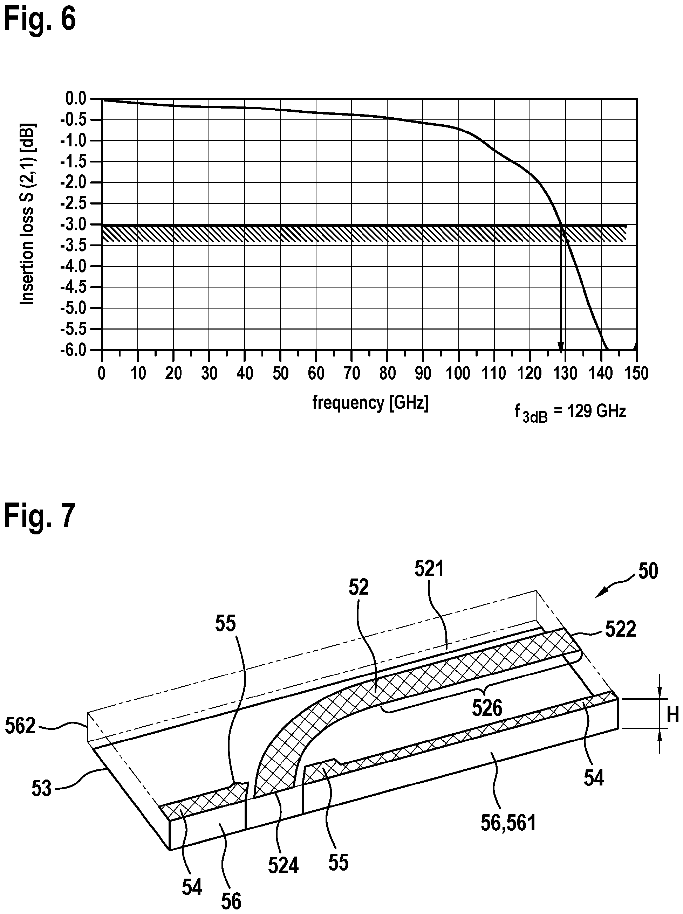

The signal submount 50 comprises in the depicted example a substrate 521. A signal trace 52 is arranged on a top surface of the substrate 521 and a ground plane 53 (see e.g. figure 7) is arranged on the opposing bottom surface. The signal trace 52 and the ground plane 53 form a waveguide in a microstrip line configuration. In comparison to the signal submount 50 of the prior art as depicted in figure 1, the thickness of the signal submount 50 of the example shown in figure 2 is reduced. Preferably, the thickness is reduced to a thickness of 150 µm or less. The side of the signal submount 50 facing towards the component submount 70 is provided with a ground shield, for example in form of a metalized side plane 56 as shown in figure 7. Further, grounded side traces 54 are arranged adjacent to an edge facing towards the component submount 70. The side of the signal submount 50 facing away from the component submount 70 is not provided with a ground shield structure. The provided ground shield prevents signal leakage and possible interference by other elements or components of the header 10, such as the thermoelectric cooler 62.

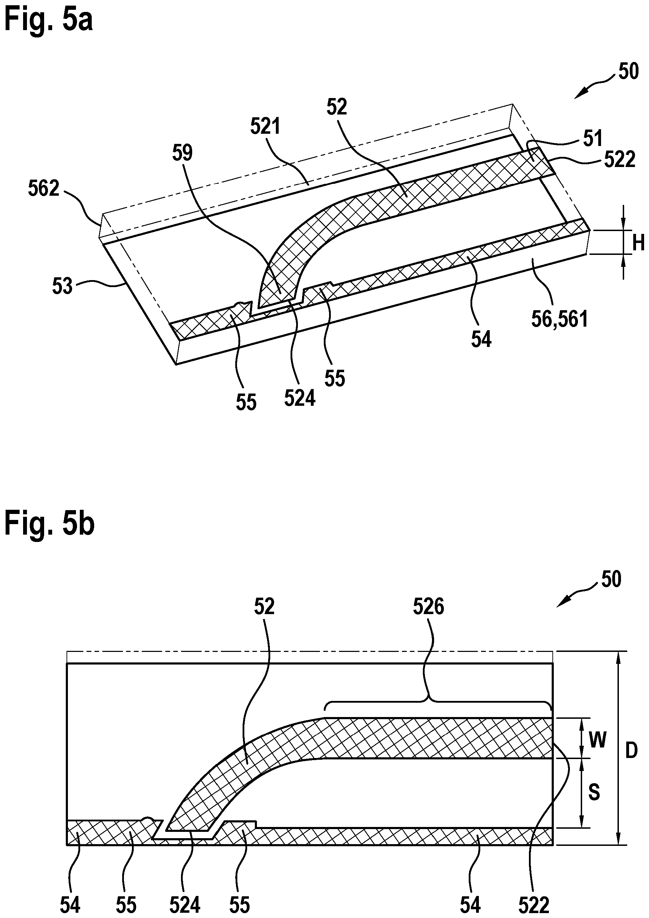

Other configurations of the signal submount 50 are possible. Further examples for suitable signal submounts 50 are depicted in figures 5a, 5b and 7 to 15b.

The signal trace 52 has a solder pad 51 which is bonded to the signal pin 20 by means of a solder material 24. The signal pin 20 has, in this example, a collar 26. The collar 26 has an increased outer diameter compared to a main part of the signal pin 20. This reduces the distance which must be bridged by the solder 24 between the signal pin 20 and the signal trace 52. At the other end, the signal trace 52 has a bond pad 59. Bond wires 80 bridge a gap between the signal submount 50 and the component submount 70 and connect the signal trace 52 to a component signal trace 72 on the component submount 70. Further, several bond wires 80 connect the ground side traces 54 to a ground plane 74 on the component submount 70. Vias 76 connect the ground plane 74 to the backside of the component submount 70. With this arrangement, a high frequency signal may be transmitted from the signal pin via the signal trace 52, the bond wires 80 and the component signal trace 72 to an optical component.

The gap between the component submount 70 and the signal submount 50 reduces the thermal mass that has to be temperature controlled by the thermoelectric cooler 62 and avoids a thermal short between the hot and cold plates of the thermoelectric cooler 62. As can best be seen from the top view of figure 3, the signal trace 52 on the signal submount 50 and the component signal trace 72 are arranged in the same plane. An offset between plane of the signal trace 52 and the plane of the component signal trace 72 is avoided, reducing the lengths of the bond wires 80.

Figures 5a and 5b depict a first example for a signal submount 50. Figure 5a shows the signal submount 50 in a perspective view and figure 5b shows the signal submount 50 in a top view.

The signal submount 50 comprises dielectric substrate 521 which is for example made of a ceramic such as aluminum-nitride (AIN). In the perspective view, the substrate 521 of the signal submount 50 is shown as transparent. The substrate 521 has a thickness H and a width D. On a top surface of the substrate 521, a signal trace 52 is located having a first end 522 which, when mounted onto the mounting part 42 of the signal pedestal 40, see figure 2, is facing towards the signal pin 20. A second end 524 of the signal trace faces towards the component submount 70, see figure 2. The first end 522 serves as solder pad 51 for electrically connecting the signal trace 52 to the signal pin 52, see figure 2. The second end 524 serves as bond pad 59 for attaching bond wires 80 to connected electrically connect the signal trace 52 to the component signal trace 72, see figure 2.

A ground plane 53 is located on a backside of the substrate 521. The signal trace 52 and the ground plane 53 form waveguide in microstrip configuration. The waveguide has in the depicted example a 45 ° bend. Thus, a first straight section 526 of the waveguide located near the first end 522 is arranged parallel to an axis of the signal pin 20 and a second part of the signal trace 52 near the second end 524 enclose an angle of 45°.

In the example depicted in figures 5a and 5b, the signal trace 52 has a constant width within a straight section 526 near the first end 522. Alternatively, the signal trace 52 can be provided with a taper, so that a width W of the signal trace 52 reduces towards the first end 522.

On a first side face of the substrate 521 facing towards the component submount 70, a ground shield is arranged which is in the example of figures 5a and 5b configured as a metallized side plane 56 covering the full area of the first side face 561. Further, a ground side trace 54 is arranged on the top surface at an edge adjacent to the first side face 561. The ground side trace 54 merges seamlessly into the metallized side plane 56 and is thus electrically connected with the metallization. Further, the side plane 56 merges seamlessly into the ground plane 53 and is thus also electrically connected to the ground plane 53.

Ground pads 55, which have an enlarged width compared to the width of a main section of the ground side trace 54 are arranged at both sides of the second end 524 of the signal trace 52. The two ground pads 55 are connected by a bridge section of the ground side trace 54 which is thin compared to the width of the main section of the ground side trace 54. The straight section 526 of the signal trace 52 is located in a distance S from the ground side trace 54, the straight section 526 of the signal trace 52 and the side trace 54 being arranged parallel to one another.

Figure 6 shows a diagram of a simulation indicating the insertion loss (S-parameter 2,1) in dB vs the frequency f in GHz for the signal submount 50 shown in figures 5a and 5b. The insertion loss indicates the damping of the signal transmitted from the first end 522 of the signal trace 52 to the second end 524. The simulation has been prepared for an impedance of 50 Ohm. The signal submount 50 has a thickness H of 150 µm and a width of 0.8 mm. In the straight section 526, the width W of the signal trace 52 is 167 µm and the slot width S is 307 µm. Material constants for aluminum nitride (AIN) were used for the submount substrate 521. The frequency for which the loss of the signal exceeds 3dB is marked, f_{3dB} = 129 GHz.

Further, the insertion loss shown diagram of figure 6 is flat and nearly constant over a large range up until about 100 GHz. No peaks or dips are present which could indicate undesired resonances.

Figure 7 shows a second example of the signal submount 50 in a perspective view. In the perspective view, the substrate 521 of the signal submount 50 is shown as transparent. The signal submount 50 depicted in Figure 7 is similar to the first example shown in figures 5a and 5b, except for the configuration of the ground shield structure. The metallized side plane 56 of the first side face 561 is interrupted in a region next to the second end 524 of the signal trace 52. The ground side trace 54 is also interrupted in this region, so that the two ground pads 55 are not directly connected. The width of the signal trace 52 is constant within the straight section 526. Alternatively, a taper towards the first end 522 can be provided.

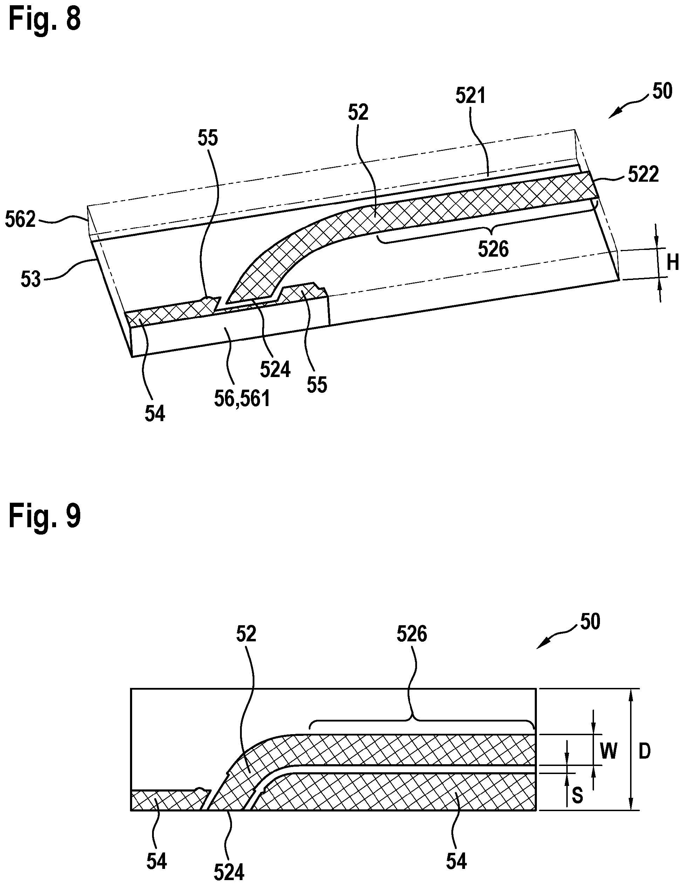

Figure 8 shows a third example of the signal submount 50 in a perspective view. The signal submount 50 depicted in Figure 8 is similar to the first example shown in figures 5a and 5b, except for the configuration of the ground shield structure. The metallized side plane 56 of the first side face 561 as well as the ground side trace do not extend over the entire length of the edge and first side face 561. The ground shield structure provided by the metallized side plane 56 and the ground side trace 54 is absent in the area next to the straight section 526 of the signal trace 52. The width of the signal trace 52 is constant within the straight section 526. Alternatively, a taper towards the first end 522 can be provided.

The straight section 526 of the signal trace 52 of the third example forms a waveguide in a pure microstrip line configuration on a substrate 521 with finite width D. The microstrip line configuration has no side trace 54 on the top side of the substrate 521.

Figure 9 shows a fourth example of the signal submount 50 in a top view. The signal submount 50 depicted in Figure 9 is similar to the first example shown in figures 5a and 5b, but has a different configuration of the ground shield structure. The width of the ground side trace 54 adjacent to the straight section 526 of the signal trace 52 is enlarged and correspondingly, the slot width S or distance between the straight section 526 of the signal trace 52 and the ground side trace 54 is reduced.

The waveguide formed in this example is a conductor-backed slot line with finite ground plane width. The electro-magnetic field is concentrated in the slot between the signal trace 52 and the ground side trace 54 and in the vicinity of the slot. This is the fundamental difference to a co-planar waveguide. A co-planar waveguide has two slots in which the electro-magnetic field is concentrated. If the signal trace 52 has a bend, the run length of the two slots and accordingly the phase of electro-magnetic field is different. At the certain phase difference, the co-planar waveguide mode is corrupt and higher order modes are excited. In contrast, the slot line doesn't show this effect.

Further, the straight section 526 of the signal trace 52 of the fourth example has a constant width W and is thus not tapered.

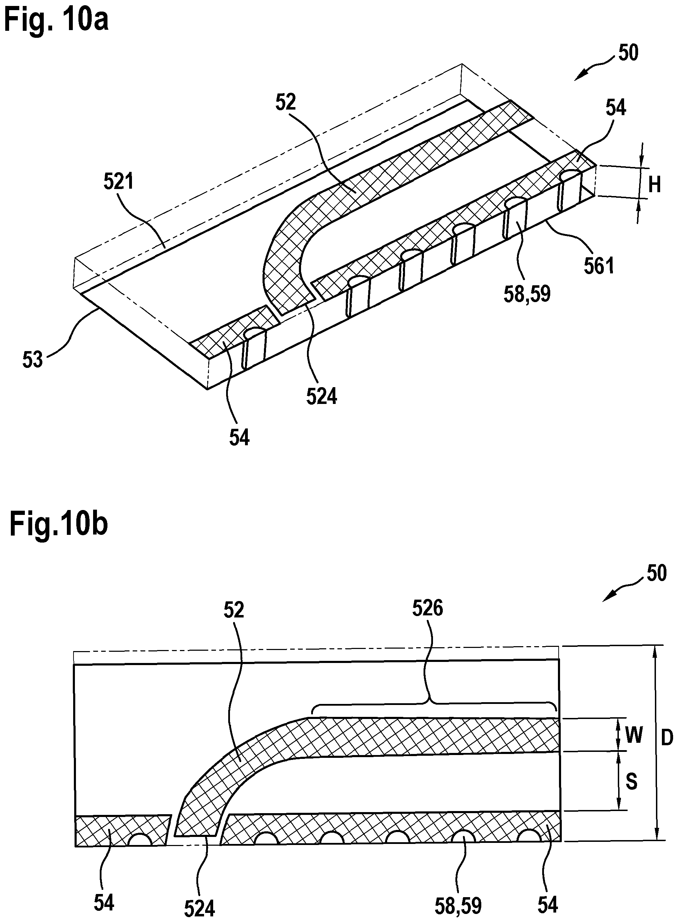

Figures 10a and 10b show a fifth example of the signal submount 50. Figure 10a depicts the signal submount 50 in a perspective view and figure 10b depicts the signal submount 50 in top view. In the perspective view, the substrate 521 of the signal submount 50 is shown as transparent. The signal submount 50 depicted in figures 10a and 10b is similar to the second example shown in figures 7, except for the configuration of the ground shield structure. Instead of a metallized side plane 56 of the first side face 561, a plurality of vias 58, are provided. The vias 58 electrically connect the ground side trace 54 on the upper surface of the substrate 521 to the ground plane 53 on the bottom surface of the substrate 521. A spacing between two adjacent vias 58 is chosen such that electromagnetic waves below a predetermined design frequency and thus a certain wavelength cannot pass through. The design frequency is at preferably least 75 GHz, more preferably at least 80 GHz. The vias 58 in the depicted example are configured as half vias 57 and are arranged directly at the first side face 561. No vias 58 are placed in the vicinity of the second end 524 of the signal trace 52, leaving a port open for electro-magnetic radiation.

In the depicted fifth example, the signal trace 52 is provided with a taper within the straight section 526 so that the width W decreases towards the first end 522. In such a case the average width of the signal trace 52 is considered as the width W of the signal trace 52.

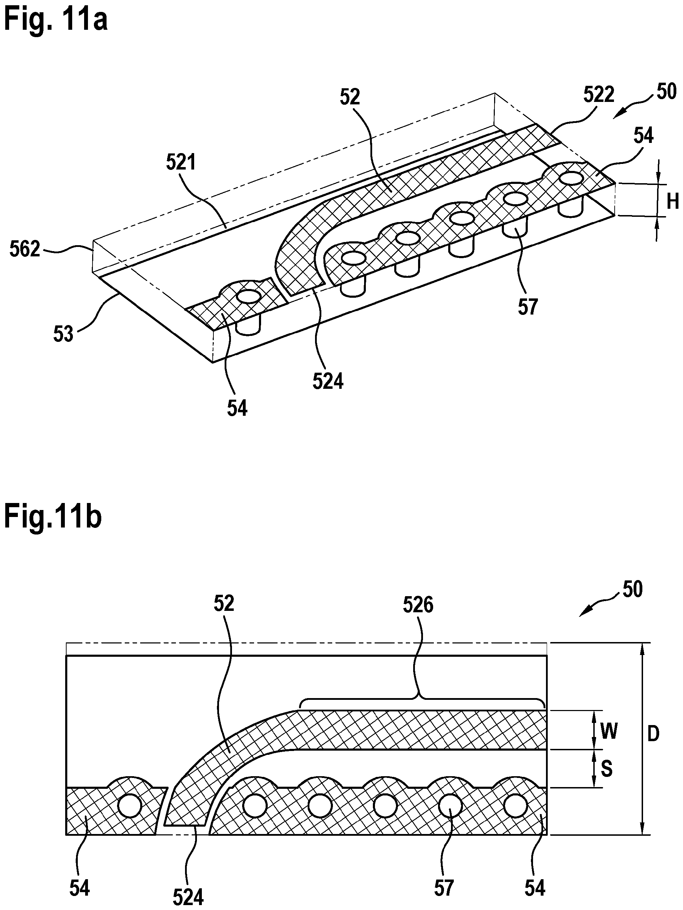

Figures 11a and 11b show a sixth example of the signal submount 50, wherein figure 11a shows a perspective view and figure 11b a top view. In the perspective view, the substrate 521 of the signal submount 50 is shown as transparent. The sixth example corresponds to the fifth example of figures 10a and 10b except for the configuration of the vias 58. In the sixth example, the vias 58 are full vias arranged fully within the substrate 521 and are not touching the first side face 561. For a reliable electrical connection between the vias 58 and the ground side traces 24, the ground side traces 24 are enlarged at the positions of the vias 58.

Further, the straight section 526 of the signal trace 52 of the sixth example has a constant width W and is thus not tapered.

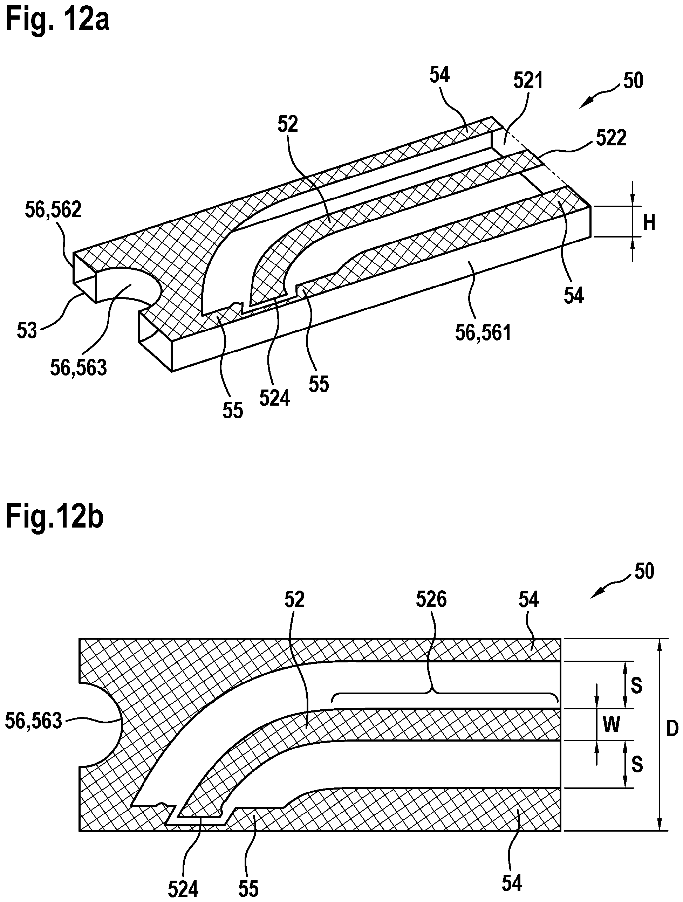

Figure 12a and 12b show a sevenths example of the signal submount 50. Figure 12a shows the signal submount 50 in a perspective view and figure 12b shows the signal submount 50 in top view. In the perspective view, the substrate 521 of the signal submount 50 is shown as transparent.

The signal submount 50 comprises dielectric substrate 521 which is for example made of a ceramic such as aluminum-nitride (AIN). The substrate has a thickness H and a width D. On a top surface of the substrate 521, a signal trace 52 is located having a first end 552 which, when mounted onto the mounting part 42 of the signal pedestal 40, see figure 2, is facing towards the signal pin 20. A second end 524 of the signal trace 52 faces towards the component submount 70, see figure 2.

A ground plane 53 is located on a backside of the substrate 521. The signal trace 52 is flanked on both sides with ground side traces 54. The ground side traces 54 and the signal trace 52 form a in coplanar waveguide configuration. The waveguide has in the depicted example a 45 ° bend. A first straight section 526 of the waveguide located near the first end 522 is arranged parallel to an axis of the signal pin 20 and a second part of the signal trace 52 near the second end 524 enclose an angle of 45°.

In the example depicted in figures 12a and 12b, the signal trace 52 has a constant width W in the straight section 526. However, embodiments with a taper near the first end 522, so that a width W of the signal trace 52 reduces towards the first end 522, are also possible.

In the example of figures 12a and 12b, the signal submount 50 is provided with ground shields in form of a metallized side plane 56 on a first side face of the substrate 521 facing towards the component submount 70, on an opposing second side face 562 and on a third side face 563 facing away from the signal pin 22. In the depicted example, the third side face 563 has an indentation or cutout in form of a semicircle. The ground side traces 54 merge seamlessly into the side planes 56 and are thus electrically connected with the metallizations. Further, the ground side planes 56 merge seamlessly into the ground plane 53 and is thus also electrically connected to the ground plane 53.

Ground pads 55, which have in this configuration a reduced width compared to the width of a main section of the ground side traces 54 are arranged at both sides of the second end 524 of the signal trace 52. The two ground pads 55 are connected by a bridge section of the ground side trace 54 which is thin compared to the width of the main section of the ground side trace 54. The straight section 526 of the signal trace 52 is located in a distance S from both of the ground side traces 54, the straight section 526 of the signal trace 52 and the side traces 54 being arranged parallel to one another.

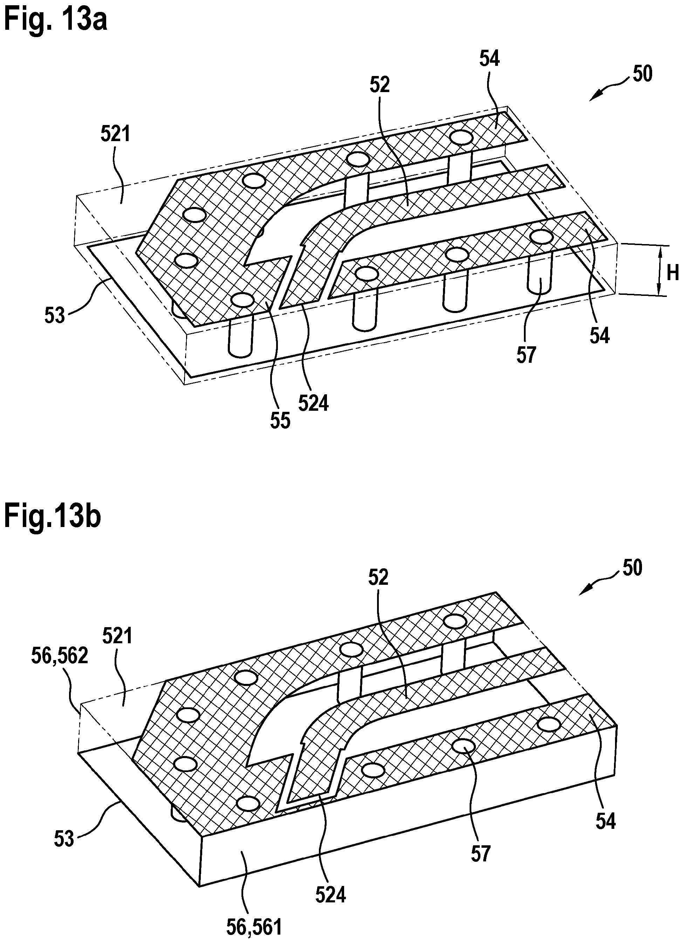

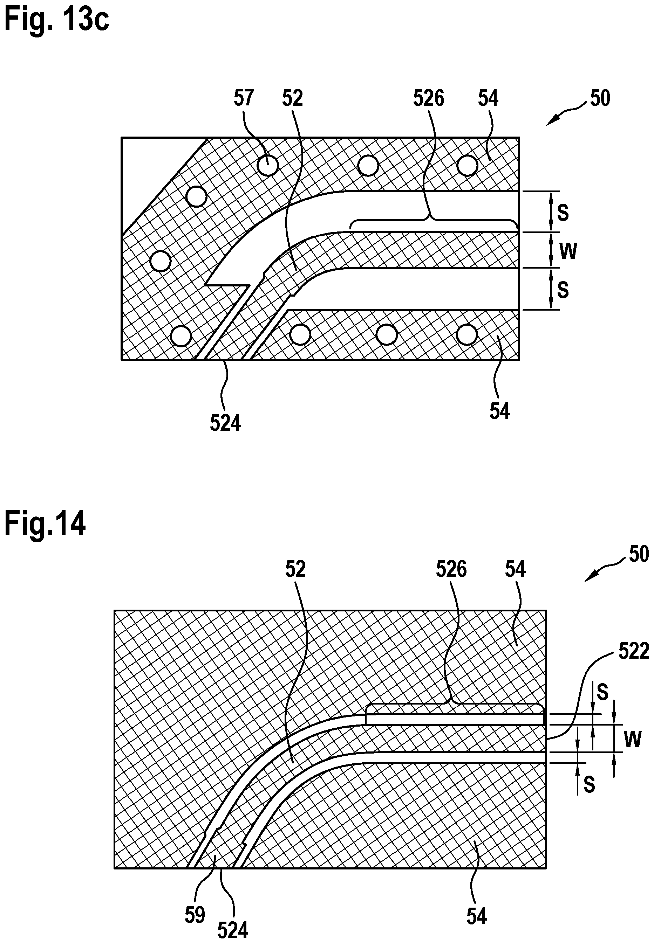

Figure 13a shows a perspective view of a eights example of the signal submount 50 and figure 13c shows the signal submount 50 in top view. In the perspective view, the substrate 521 of the signal submount 50 is shown as transparent.

The eights example of figures 13a and 13c is similar to the seventh example of figures 12a and 12b but features a different configuration of the ground shield structure.

The ground shield is provided by vias 57 instead of metallization of the side faces 561, 562, 563. The vias 57 are arranged closely together to form a block for electromagnetic waves having a frequency below a set design frequency, which is preferably at least 75 GHz, more preferably at least 80 GHz.

Additionally, one of the ground pads 55 flanking the second end 524 of the signal trace 52 is enlarged and the ground pads 55 are not directly connected by a bridge. No via 57 is placed directly in the vicinity of the second end 524, leaving a port open for electro-magnetic radiation.

Figure 13b shows a perspective view of a variant of the signal submount 50 of figure 13a. A top view is shown in figure 13c.

The variant shown in figures 13b and 13c is identical the example shown in figures 13a and 13c but has additional metallizations arranged on the first side face 561 facing towards the component submount 70 and the opposite second side face 562 to provide grounded side planes 56 in addition to the vias 58.

Figure 14 shows a top view of a nineths example of the signal submount 50

The signal submount 50 is provided with a signal trace 52 which is flanked on both sides with ground side traces 54, forming a waveguide in coplanar configuration. The waveguide has a 45 ° bend. A first straight section 526 of the waveguide located near the first end 522 is arranged parallel to an axis of the signal pin 20 and a second part of the signal trace 52 near the second end 524 enclose an angle of 45°.

In the example depicted in figure 14, the signal trace 52 has a constant width W in the straight section 526. However, embodiments with a taper near the first end 522, so that a width W of the signal trace 52 reduces towards the first end 522, are also possible. At the second end 524, a bond pad 59 of the signal trace 52 has an enlarged width. Compared to the width W within the straight section 526.

In the example of figure 14, the slot width S, which is the distance between the signal trace 52 and the ground side traces 54 is constant within the straight section 526 and is smaller than the width W of the signal trace 52.

The ground shield structures of the tenths example can be provided in form of metallized side planes 56, similar to those shown in figure 12a, can be provided in form of vias 57, as shown for example in figure 13a and can be a combination of side planes 56 and vias 57 as shown for example in figure 13b.

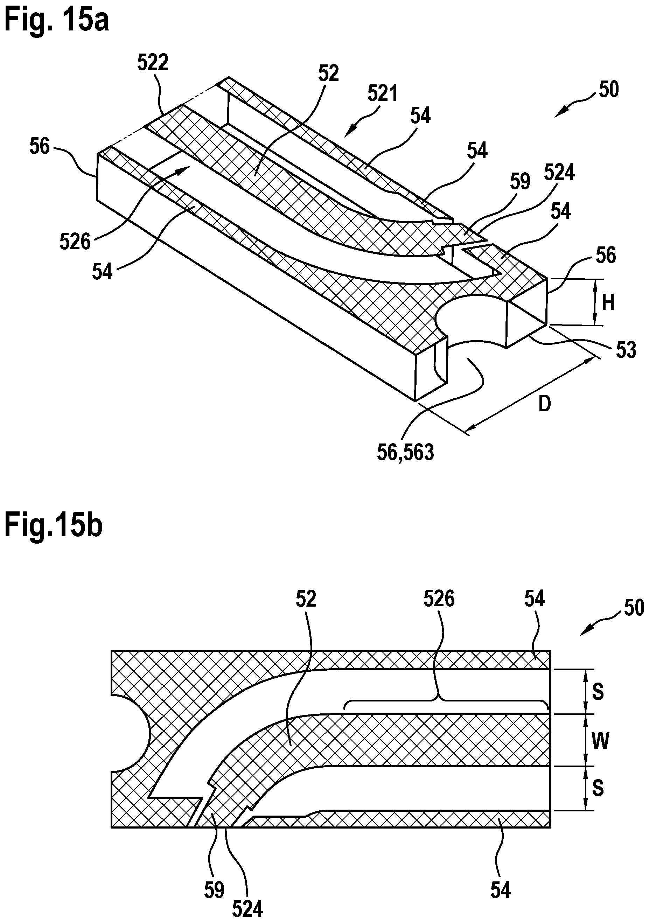

Figure 15a and figure 15b show a tenths example of the signal submount 50. Figure 15a shows the signal submount 50 a perspective view of and figure 15b shows the signal submount 50 in top view. In the perspective view, the substrate 521 of the signal submount 50 is shown as transparent.

The signal submount 50 comprises dielectric substrate 521 which is for example made of a ceramic such as aluminum-nitride (AIN). The substrate 521 has a thickness H and a width D. On a top surface of the substrate 521, a signal trace 52 is located having a first end 522 which, when mounted onto the mounting part 42 of the signal pedestal 40, see figure 2, is facing towards the signal pin 20. A second end 524 of the signal trace 52 faces towards the component submount 70, see figure 2.

A ground plane 53 is located on a backside of the substrate 521. The signal trace 52 is flanked on both sides with ground side traces 54. The ground side traces 54 and the signal trace 52 form waveguide in coplanar configuration. The waveguide has in this example a 45 ° bend. A first straight section 526 of the waveguide located near the first end 522 is arranged parallel to an axis of the signal pin 20 and a second part of the signal trace 52 near the second end 524 enclose an angle of 45°.

In the tenth example depicted in figures 15a and 15b, the signal trace 52 has a constant width W in the straight section 526. However, embodiments with a taper near the first end 522, so that a width W of the signal trace 52 reduces towards the first end 522, are also possible.

In the tenth example, the signal submount 50 is provided with ground shields in form of metallized side planes 56 on a first side face 561 of the substrate 521 facing towards the component submount 70 and on an opposing second side face 562. A third side face 563 facing away from the signal pin 22 is in this example provided with a cut out in form of a semi-circle. The wall of the cutout is metallized to provide a further metallized side plane 56. The ground side traces 54 merge seamlessly into the metallized side planes 56 and are thus electrically connected with the side planes 56. Further, the side planes 56 merge seamlessly into the ground plane 53 and are thus also electrically connected to the ground plane 53. The metallized side plane 56 on the first side face 561 is interrupted in the region adjacent to the second end 524 of the signal trace 52, providing a port for electromagnetic radiation.

Ground pads 55 are arranged at both sides of the second end 524 of the signal trace 52. The two ground pads 55 are in this example not directly connected by a bridge section. The ground pads 55 facing towards the signal pin 22 has in this configuration a reduced width compared to the width of a main section of the ground side trace 54. Also, the ground side traces 54 are not symmetrical, one of the ground side traces 54 having a larger width than the other.

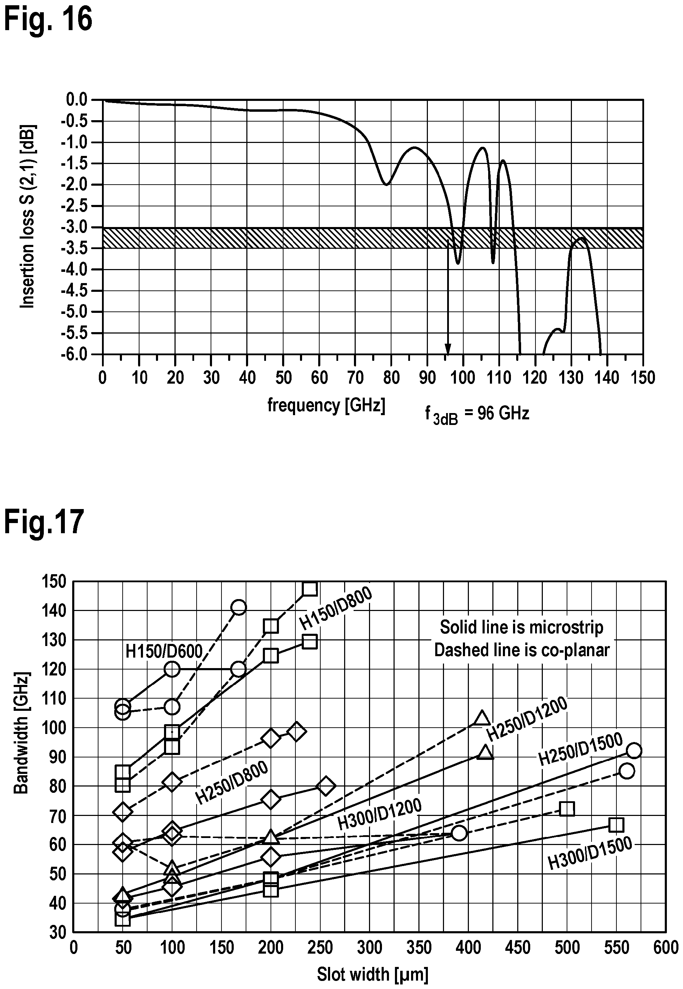

Figure 16 shows a diagram indicating the insertion loss (S-parameter 2,1) in dB vs the frequency f in GHz for the signal submount 50 of the tenth example shown in figures 15a and 15b.

The insertion loss indicates the damping of the signal transmitted through the signal trace 52 signal submount 50 from the first end 522 facing towards the signal pin 20 to the second end 524 facing towards the component submount 70. The simulation has been prepared by means of a 3D FEM simulation with a signal line termination of 50 Ohm. The signal submount 50 has a thickness H of 250 µm and a width D of 0.8 mm. In the straight section 526, the signal trace 52 has a width W of 239 µm and a slot width S of 200 µm.

Further, the insertion loss shown diagram of figure 16 is flat until a frequency of about 70 GHz. Two local minima are present in the frequency range of 70 and 100 GHz. The 3 dB bandwidth is 96 GHz.

Figure 17 shows a diagram indicating the -3dB bandwidth of headers 10 using different signal submounts 50.

Embodiments having a waveguide in microstrip configuration, such as shown in figures 5a to 11b, are indicated by a solid line. Embodiments having a waveguide in coplanar configuration, such as shown in figures 12a to 15b, are indicated by a dashed line. The submount thickness H was varied between 150 µm and 300 µm, and the submount width D was varied between 600 µm and 1500 µm. The slot width was varied between 50µm and 550 µm. Material constants for aluminum nitride (AIN) were used for the submount substrates.

In each case, the signal trace 52 was designed without a taper and thus with a constant width W within the straight section 526. The simulation was prepared by means of a 3D FEM simulation with a signal line termination of 50 Ohm.

As can be seen from the diagram of figure 17, the -3dB bandwidth increases for increasing slot width S. This is surprising as it is expected that a waveguide having a narrow slot width provides better containment of the signal. Further, it can be seen that waveguides having a thin substrate 521 have a higher bandwidth than waveguides having thicker substrates 521. Still further, narrow signal submounts 50 with a low width D perform better and provide a higher bandwidth than wider signal submounts 50.

Configurations having a slot width S of 100 µm or less achieve high bandwidths in excess of 75 GHz only when combined with thin and narrow submount substrates 521.

Figure 18 shows a perspective view of the header 10 including an optoelectronic component 90.

The shown header 10 corresponds to the header 10 described with respect to figures 2, 3 and 4, but a laser diode 91 as optoelectronic component 90 is mounted on the component submount 70. Further, a monitoring diode 92 for monitoring the power of the laser diode 91 is included on the component submount 70 and a thermal sensor 94 is mounted on the mounting part 68 of the component pedestal 60. The thermal sensor 94 may be used in combination with the thermoelectric cooler 62 to provide temperature control for the laser diode 91 and the monitoring diode 92 may be used to control the output power of the laser diode 91.

Figure 19 shows an electro optical converter 110 having transistor outline (TO) housing 100 comprising a header 10 and a window cap 102. The window cap 102 includes a window 104 which allows electromagnetic radiation, such as light emitted by the laser diode 91, to be transmitted through the window cap 102. The window 104 may be configured as a lens for focusing/coupling the beam emitted by the laser diode 91 into a core of a fiber optic.

Although the present invention has been described with reference to preferred examples of embodiments, it is not limited thereto but can be modified in a variety of ways.

### List of reference numerals

- 1': header (prior art)
- 1: header

- 10: header base
- 12: opening

- 20: signal pin
- 22: pin
- 24: solder
- 26: collar

- 30: fixation material

- 40: signal pedestal
- 42: mounting part

- 50: signal submount
- 51: solder pad
- 52: signal trace
- 521: substrate
- 522: end facing signal pin
- 524: end facing component submount
- 526: straight section

- 53: ground plane at bottom side
- 54: ground side trace
- 55: ground pad
- 56: side plane
- 561: first side face
- 562: second side face
- 563: third side face
- 57: via
- 58: half via
- 59: bond pad

- S: slot width
- W: signal trace width
- H: submount thickness
- D: submount width
- O: offset

- 60: component pedestal
- 62: thermoelectric cooler
- 63: hot plate
- 64: cold plate
- 65: Peltier Element
- 68: mounting part

- 70: component submount
- 72: component signal trace
- 74: ground plane
- 76: via

- 80: bond wire

- 90: optoelectronic component
- 91: laser diode
- 92: monitor diode
- 94: thermal sensor

- 100: TO package
- 102: cap
- 104: window (lens)

- 110: electro-optical converter

## Claims

1. Header (1) for an optoelectronic component (90) comprising a header base (10) having at least one signal pin (20) which is fed through an opening (12) in the header base (10) and fixed within the opening (12) with a fixation material (30), a component pedestal (60) having a component submount (70) configured for mounting the optoelectronic component (90), and a signal pedestal (40), wherein a signal submount (50) is arranged on the signal pedestal (40), the signal submount (50) having a signal trace (52) which is electrically connected to the signal pin (20), **characterized in that**
i) the signal submount (50) has a signal submount thickness H of at most 150 µm, wherein the signal submount (50) is arranged such that an offset between a plane of the signal trace (52) of the signal submount (50) to the plane of a component signal trace (72) of the component submount (70) is less than +/- 200 µm, preferably less than +/- 100 µm and/or
ii) the signal submount (50) has at least one grounded side trace (54), the width D of the signal submount (50) is at most 1000 µm, the thickness H of the signal submount (50) is in the range of from 150 µm to 300 µm, and a slot width S between the signal trace (52) and the grounded side trace (54) S is at least 100 µm, and/or
iii) the signal submount (50) has a ground plane (53) on the side opposite to the signal trace (52), wherein a first side face (561) of the signal submount (50) is at least partially metallized and/or a plurality of vias (58, 59) is arranged adjacent to the first side face (561) to provide a ground shield, and an opposing second side face (562) of the signal submount (50) is free from a ground shield.

2. The header (1) according to claim 1, wherein the signal submount (50) has a grounded side plane (56), wherein the grounded side plane (56) is arranged on the first side face (561) which is facing towards the component submount (70), or wherein the signal submount (50) has a plurality of ground vias (57, 58) arranged adjacent to an edge facing toward the component submount (70).

3. The header (1) according to claim 2, wherein the signal submount (50) has a ground side trace (54) on the plane of the signal trace (52), the ground side trace (54) being arranged adjacent to an edge such that the ground side trace (54) merges seamlessly into the ground side plane (56).

4. The header (1) according to any one of claims 1 to claim 3, wherein the signal submount (50) has a ground side trace (54) on the plane of the signal trace (52), and wherein a second end (524) of the signal trace (52) facing towards the component submount (70) is flanked on one or both sides with ground pads (55) being connected to the ground side trace (54) and having a width that is larger than a width of the ground side trace (54).

5. The header (1) according to any one of claims 1 to 4, wherein the signal trace (52) is flanked on one or both sides with ground side traces (54).

6. The header (1) according to any one of claims 1 to 5, wherein a bond pad (59) at a second end (524) of the signal trace (52) facing towards the component submount (70) has a width which is enlarged compared to the width (W) of the signal trace (52) or has a width which is reduced compared to the width (W) of the signal trace (52).

7. The header (1) according to any one of claims 1 to 6, wherein a solder pad (51) at a first end (522) of the signal trace (52) facing towards the signal pin (20) has a width which is reduced compared to the width (W) of the signal trace (52).

8. The header (1) according to any one of claims 1 to 7, wherein the signal trace (52) of the signal submount (50) is, at a first end (522) facing towards the signal pin (20), arranged parallel to an axis of the signal pin (20), and at a second end (524) facing towards the component submount (70) arranged at an angle of from 40° to 50° or 80° to 100° relative to the axis of the signal pin (20).

9. The header (1) according to any one of claims 1 to 8, wherein the component pedestal (60) comprises a thermoelectric cooler (62) configured to control the temperature of an optoelectronic component (90) mounted on the component submount (70).

10. The header (1) according to claim 9, wherein a thermoelectric cooler (62) has a cold plate (64) and a hot plate (63), the cold plate (64) and the hot plate (63) being spaced apart by intermediate Peltier elements (65), and wherein the thermoelectric cooler (62) is mounted on the bottom of a cavity in the header base (10) with its hot plate (63), so that the Peltier elements (65) are arranged at least partially inside the cavity and below a surface level of an upper side of the header base (10).

11. The header (1) according to any one of claims 1 to 10, wherein the signal submount (50) is configured such that a submount width D and the submount thickness H fulfill the condition D >= 5H, and/or
such that a submount width D and the signal trace width W fullfill the condition D>=2.5W.

12. The header (1) according to any one of claims 1 to 11, wherein the signal submount (50) has at least one ground side trace (54) and is configured such that a slot width S between the signal trace (52) and an adjacent ground side trace (54) and width W of the signal trace (52) fulfill the condition S/W is greater than or equal to 0.5, preferably greater than or equal to 0.7.

13. Header (1) according to any one of claims 1 to 12, wherein a substrate material of the submount (50) is a ceramic, preferably AIN or Al₂O₃.

14. The header (1) according to any one of claims 1 to 13, wherein a straight section (526) of the signal trace (52) is arranged in the middle of the signal submount (50), and/or
wherein the signal trace (52) has a straight section (526) connected to the signal pin (22) by means of a solder material (24) and wherein the straight section has a constant width or a taper in a direction towards the signal pin (22).

15. A TO package (100) comprising the header (1) according to any one of the preceding claims 1 to 14 and a cap (102) with a window (104) for transmitting the radiation emitted from at least one laser diode (91) mounted on a thermoelectric cooler (62), the thermoelectric cooler (62) and the laser diode (91) mounted thereon being encapsulated in the volume formed between the header (1) and the cap (102), the laser diode (91) and the thermoelectric cooler (62) being connected to pins (20, 22) extending through the header base (10).

16. An electro-optical converter (110) for high-speed data communication with transmission rates of at least 100 GBit/s, comprising a TO package (100) according to the preceding claim.
